# FASCICULE DE BREVET EUROPEEN

(11) **EP 1 252 662 B1**
(45) Date de publication et mention de la délivrance du brevet: **03.09.2003**
(21) Numéro de dépôt: 00967979.6
(22) Date de dépôt: 09.10.2000
(51) Int. Cl.: H01L 39/14, H01L 39/24, H01B 12/10, C22C 21/00

(54) **CONDUCTEUR SUPRACONDUCTEUR COMPORTANT UN STABILISATEUR CRYOGENIQUE A BASE D'ALUMINIUM**
SUPRALEITER MIT KRYOGENEM STABILISATOR AUF ALUMINIUMBASIS
SUPRACONDUCTIVE CONDUCTOR COMPRISING AN ALUMINIUM-BASED CRYOGENIC STABILISER

(43) Date de publication de la demande: 30.10.2002
(73) Titulaire: ALUMINIUM PECHINEY, 75218 Paris Cedex 16 (FR)
(72) Inventeur: LEROY, Michel, F-38120 Saint Egrève (FR)
(74) Mandataire: Marsolais, Richard
(86) Numéro de dépôt international: FR0002795
(87) Numéro de publication internationale: WO02031894

(56) Documents cités:
- WO-A-00/17890
- WADA K ET AL: "High-strength and high-RRR Al-Ni alloy for aluminum-stabilized superconductor" 16TH INTERNATIONAL CONFERENCE ON MAGNET TECHNOLOGY, TALLAHASSEE, FL, USA, 26 SEPT.-2 OCT. 1999, vol. 10, no. 1, mars 2000 (2000-03), pages 1012-1015, XP002169351 IEEE Transactions on Applied Superconductivity ISSN: 1051-8223
- WADA K ET AL: "Development of high-strength and high-RRR aluminum-stabilized superconductor for the ATLAS thin solenoid" 16TH INTERNATIONAL CONFERENCE ON MAGNET TECHNOLOGY, TALLAHASSEE, FL, USA, 26 SEPT.-2 OCT. 1999, vol. 10, no. 1, mars 2000 (2000-03), pages 373-376, XP002169352 IEEE Transactions on Applied Superconductivity ISSN: 1051-8223 cité dans la demande
- PATENT ABSTRACTS OF JAPAN vol. 006, no. 250 (C-139), 9 décembre 1982 (1982-12-09) & JP 57 145957 A (SUMITOMO ELECTRIC IND CO), 9 septembre 1982 (1982-09-09)

## Description

### Domaine de l'invention

L'invention concerne les conducteurs supraconducteurs, tels que des fils monobrins ou des câbles supraconducteurs, comportant un stabilisateur cryogénique à base d'aluminium.

Sauf indication contraire, les compositions sont exprimées en valeurs pondérales.

### État de la technique

L'utilisation de champs magnétiques très élevés, de plusieurs teslas, pour des applications telles que la sustentation magnétique des véhicules, la résonance magnétique nucléaire (RMN) ou la physique des particules élémentaires, nécessite l'emploi de conducteurs supraconducteurs, notamment sous forme de câbles, aptes à transporter de fortes densités de courant, typiquement supérieures à 10⁵ A/cm², avec de très faibles pertes énergétiques. Ces conducteurs, dont les plus utilisés sont à base
d'alliages au niobium tels que Nb-Ti et, parfois, Nb-Zr, ne deviennent supraconducteurs qu'au dessous d'une température critique Tc très basse, qui nécessite un refroidissement à l'hélium liquide, et ils ne le demeurent que si le champ magnétique auquel ils sont soumis ne dépasse pas une valeur critique Hc. Il faut donc éviter qu'une perturbation thermique, mécanique ou magnétique localisée conduisant à une perte locale de supraconductivité ne se propage à l'ensemble du conducteur et n'en entraîne, éventuellement, la dégradation irréversible.

Pour ces raisons, les câbles supraconducteurs sont généralement constitués d'une multitude de filaments supraconducteurs de faible section unitaire (typiquement ⌀ < 50 µm) enrobés dans une matrice métallique, formant ainsi une "âme supraconductrice", et gainés d'un métal à haute conductivité électrique et thermique, tel que le cuivre ou l'aluminium, qui puisse assurer l'évacuation rapide des calories vers le bain d'hélium liquide et la protection mécanique des filaments, notamment au cours des opérations de mise en forme. Ces opérations comportent des étapes successives de corroyage (tel que filage ou tréfilage) et de traitements thermiques (tel qu'un recuit) qui permettent d'assurer un bon contact électrique et thermique entre l'âme supraconductrice et ledit métal de gainage, qui est connu sous le nom de "gainage stabilisateur" ou "stabilisateur cryogénique" ou tout simplement "stabilisateur". D'une façon générale, les âmes supraconductrices occupent 10 à 40 % de la section des câbles supraconducteurs et le gainage stabilisateur en occupe 60 à 90 %. Les filaments supraconducteurs sont généralement en alliage au niobium, tel que NbTi. Ladite matrice métallique possède des conductivités électrique et thermique élevées et assure la cohésion et la protection mécanique des filaments lors des étapes de fabrication du câble. Elle est généralement en cuivre ou alliage de cuivre de haute pureté et plus rarement en aluminium ou alliage d'aluminium de haute pureté (au moins 99,999 % aluminium).

Il est connu d'utiliser de l'aluminium dans les stabilisateurs cryogéniques (ou cryostatiques) de conducteurs supraconducteurs. L'aluminium présente l'avantage de posséder des conductivités électrique et thermique très élevées à basse température, une faible densité, une chaleur spécifique faible et une grande transparence aux différents types de rayonnement. Il est généralement admis que le choix d'un aluminium particulier se fait en fonction de sa résistivité à la température de l'hélium liquide (4,2 K), dite "résistivité résiduelle", qui est exprimée en termes du rapport, appelé RRR, entre la résistivité à la température ambiante et la résistivité résiduelle. Comme la conductivité thermique de l'aluminium et de ses alliages est, à 4,2 K, sensiblement proportionnelle au RRR, un aluminium dont le RRR est élevé permet donc d'évacuer plus efficacement la chaleur qui pourrait être dégagée lors d'une perte locale de supraconductivité d'un ou plusieurs filaments supraconducteurs.

Puisque la résistivité électrique résiduelle de l'aluminium dépend fortement des impuretés ou éléments d'alliages qu'ils contient, on utilise en règle générale une base d'aluminium de très haute pureté, à savoir un aluminium de pureté au moins égale à 5N, c'est-à-dire un aluminium pur contenant au moins 99,999 % en poids d'aluminium, et particulièrement pauvre en éléments susceptibles de dégrader la résistivité (tels que Ti, V, Zr, Mn ou Fe). L'utilisation de bases aluminium d'une aussi grande pureté augmente considérablement le coût de fabrication des stabilisateurs et des conducteurs supraconducteurs.

Dans la plupart des applications, les stabilisateurs cryogéniques doivent également être aptes à supporter des contraintes mécaniques de traction ou de compression importantes, qui proviennent en grande partie de forces électromagnétiques. Ces contraintes, qui peuvent avoir un caractère cyclique, entraînent notamment une déformation du stabilisateur et une augmentation de la résistance résiduelle au cours du temps ou simplement au moment du bobinage ou du refroidissement à la température de l'hélium liquide.

Afin de pallier ces inconvénients, il est connu de la demande européenne EP 500 101 (correspondant au brevet américain US 5 266 416), d'utiliser un stabilisateur cryogénique en un alliage d'aluminium ayant une limité élastique à 0,2 % d'allongement, à très basse température (typiquement à 4,2 K), au moins égale à 40 MPa et un RRR au moins égal à 250. De telles caractéristiques peuvent être obtenues en utilisant du Zn, Si, Ag, Cu ou Ce en tant qu'éléments d'additions ajoutés à une base aluminium de pureté au moins égale à 5N. De telles propriétés mécaniques sont cependant insuffisantes pour des applications telles que l'imagerie médicale par RMN (Résonance Magnétique Nucléaire). Pour cette application, on utilise actuellement, et quasi-universellement, un gainage stabilisateur en cuivre présentant une résistivité résiduelle à l'hélium liquide inférieure à 5,4 nΩ.cm et une limite élastique, mesurée à la température ambiante, supérieure à 80 MPa. Cette solution a pour inconvénient la grande densité du cuivre qui alourdit fortement les bobinages et en augmente le coût tant direct qu'indirect (par exemple par l'utilisation de supports de bobines plus conséquents).

Il a aussi été proposé, dans la demande française FR 2 707 419 (correspondant au brevet américain US 5 573 861), d'utiliser un stabilisateur cryogénique en aluminium de haute pureté (de 99,9 à 99,9999 % en poids) dont la structure cristalline possède une orientation spécifique par rapport au sens longitudinal du conducteur. Cependant, une telle orientation préférentielle du grain après filage nécessite l'utilisation d'un aluminium extrêmement pur, très faiblement allié, et ayant donc des propriétés mécaniques très insuffisantes pour de nombreuses applications.

Dans le même but, il a également été proposé, dans la demande française FR 2 707 420 (correspondant aux brevets américains US 5 753 380 et 5 733 389), d'utiliser un stabilisateur cryogénique en aluminium de haute pureté (de 99,8 à 99,9999 % en poids) contenant au moins un élément métallique ou semi-métallique dit "actif", tel que notamment B, Ca, Ce, Ga, Y, Yb et Th, dont la plus grande partie serait en solution solide. Les résultats publiés montrent également des propriétés mécaniques très inférieures à celles du cuivre.

Il est également connu, par l'article de A. Yamamoto et al., "Design and Development of the ATLAS Central Solenoid Magner", paru dans IEEE Transactions on Applied Superconductivity, pp. 852-855, VoL 9, n° 2, Juin 1999, d'utiliser un alliage d'aluminium à base 5N avec 1000 ppm en poids de Ni qui permet d'obtenir un stabilisateur dont le RRR est de 600 environ et la limite élastique à 0,2 % d'allongement est de 110 MPa à 4,2 K et de 81 MPa à 300 K, après un étirage à froid correspondant à un allongement de 27 % et à une réduction de section de 21 % (1/1,27 = 0,79). Un allongement à froid aussi important du composite formé par l'âme supraconductrice et de son gainage stabilisateur est cependant à la limite de ce que peut supporter un tel composite sans striction locale ou rupture.

Par la demande internationale WO 00/17890, on connaît également un procédé de fabrication de câbles supraconducteurs comportant un stabilisateur en alliage d'aluminium à durcissement par précipitation, à base très pure, contenant de 100 ppm à 25000 ppm de Ni. Selon ce procédé, l'alliage est soumis à un traitement thermique de précipitation, à une température comprise entre 250 °C et 500 °C, avant d'opérer le recouvrement de l'âme supraconductrice par extrusion à chaud. Partant d'une base aluminium très pure (typiquement 5N selon les exemples 1 à 3), outre le Ni, il est également possible d'ajouter des éléments qui ne font pas augmenter la résistivité de l'aluminium et qui sont choisis parmi Ag, As, Bi, Ca, Cd, Cu, Ga, Mg, Pb, Sc, Si, Sn et Zn. La somme des éléments de l'alliage autres que ceux-ci (tels que le Fe) ne peut dépasser 10 ppm.

Les propriétés mécaniques du câble mixte (composite) comportant une âme supraconductrice et un revêtement stabilisateur en alliage d'aluminium ont été mesurées à la température de l'hélium liquide (4,2 K). Les valeurs correspondant à l'alliage d'aluminium seul (i.e. sans l'âme supraconductrice) ne sont pas données, mais elles sont nécessairement très sensiblement inférieures à celles du composite car les propriétés mécaniques de l'âme supraconductrice, qui est formée de filaments de supraconducteur Nb-Ti enrobés dans du cuivre écroui et qui constitue une partie importante de la section du câble, sont très élevées. En outre, les propriétés mécaniques de l'alliage d'aluminium mesurées à 4,2 K sont très supérieures à celles mesurées à température ambiante (300 K) comme on le verra dans les paragraphes suivants.

Dans une présentation intitulée "Progress in ATLAS Central Solenoid Magnet" présentée à la 16^{ème} International Conference on Magnet Technology (Floride, 1999), Yamamoto et al. ont indiqué, pour un alliage Al + 0,1 % Ni (c'est-à-dire un alliage ne contenant aucun élément d'alliage-autre que Ni) traité par précipitation à 430 °C et après réduction finale de section de 21 % à froid, les valeurs suivantes :
- limite élastique de l'alliage à 4,2 K = 110 MPa ;
- RRR de l'alliage = 570 ;
- limite élastique du câble composite à 4,2 K = 146 MPa,
ce qui démontre l'effet de "renfort" joué par l'âme supraconductrice dans le câble composite.

Au cours de la même conférence, dans une présentation intitulée "Development of High-Strength and High-RRR Aluminum Stabilized Superconductor for the ATLAS Thin Solenoid", K. Wada et al. ont présentés des résultats sur des alliages à 0,05 % et 0,1 % Ni formés par addition de Ni à l'aluminium base SN, sans aucun autre élément d'addition. Ils ont indiqué, pour leur part, des valeurs obtenues sur échantillons de laboratoire (L.E désigne la limite élastique) qui sont regroupées dans le tableau A.

Pour les câbles industriels, les valeurs mesurées sur le stabilisateur en alliage à 0,1 % de Ni ayant subi une réduction finale de section, à froid, de 21 % donnent :
- RRR = 591 à 593 ;
- L.E 0,2 % à température ambiante = 80 à 83 MPa ;
- L.E 0,2 % à 4,2 K = 110 MPa.

On constate, sur cet exemple, l'écart important des propriétés mécaniques de l'alliage d'aluminium entre la température ambiante et 4,2 K.

Par ailleurs, les auteurs attribuent cette amélioration sensible des performances du produit industriel, par rapport aux échantillons de laboratoire, à des conditions de transformation légèrement différentes et plus favorables.

**Tableau A**

| Réduction finale de la section | 15 % | | 20 % | | 25 % | |
|---|---|---|---|---|---|---|
| Alliage | L.E 0,2 % (MPa) | RRR | L.E 0,2 % (MPa) | RRR | L.E 0,2 % (MPa) | RRR |
| Al + 0,05 % Ni | 57,3 | 620 | 63,9 | 583 | 67,3 | 564 |
| Al + 0,1 % Ni | 60,5 | 522 | 67,7 | 530 | 70,2 | 517 |

La demanderesse a recherché des moyens pour obtenir simultanément, à des coûts acceptables pour un usage industriel (tel que la fabrication en série de bobines supraconductrices destinées à des appareils d'imagerie par RMN), une résistivité résiduelle à 4,2 K inférieure à 5,4 nΩ.cm (soit un RRR par rapport à 300 K supérieur à environ 500) et des propriétés mécaniques renforcées, c'est-à-dire une limite élastique à 0,2 % d'allongement (L.E à 0,2 %), mesurée à température ambiante, supérieure à 75 MPa, et de préférence supérieure à 85 MPa, et ceci en partant d'une base aluminium moins coûteuse que la base de pureté 5N habituelle pour ce genre de produit.

### Description de l'invention

L'invention a pour objet un conducteur supraconducteur, tel qu' un fil ou un câble supraconducteur, comportant au moins une âme supraconductrice et un stabilisateur cryogénique constitué, en tout ou partie, d'un alliage d'aluminium de haute pureté ayant la composition suivante :
200 ppm ≤ Fe + Ni ≤ 1500 ppm ;
0,20 ≤ Fe / (Fe + Ni) ≤ 0,65 ;
optionnellement, B < 100 ppm ;
reste aluminium de pureté supérieure à 99,99 % en poids.

L'invention a aussi pour objet une préforme de stabilisateur cryogénique constituée dudit alliage d'aluminium de haute pureté.

La demanderesse a constaté que, de façon tout à fait surprenante, la présence simultanée de fer (Fe) et de nickel (Ni), en tant qu'éléments d'alliage, dans les proportions revendiquées, permettait d'obtenir, avec un aluminium de base de pureté 4N, des compromis RRR/propriétés mécaniques sensiblement plus performants que ceux des alliages binaires, et ceci avec des quantités d'éléments d'alliage plus faibles et des étirages finaux à froid plus modérés, ce qui évite tout risques de rupture du conducteur pendant cette dernière opération. Par exemple, on peut obtenir simultanément un RRR > 600 et une limite élastique à température ambiante supérieure à 85 MPa avec un alliage contenant moins de 700 ppm de Fe + Ni. D'une façon générale, le fer n'est pas recommandé, en tant qu'élément d'addition à une base aluminium pure, malgré sa limite de solubilité très faible dans l'aluminium solide à des températures modérées (200 à 400 °C) car son coefficient de diffusion dans l'aluminium est très faible et qu'il faudrait des maintiens de durée incompatible avec un usage industriel (c'est-à-dire plusieurs semaines) pour s'approcher de cette limite de solubilité.

L'invention a aussi pour objet un procédé d'obtention d'une préforme de stabilisateur cryogénique destinée à la fabrication d'un conducteur supraconducteur selon l'invention, qui comprend la formation d'une préforme initiale à l'état brut et une opération de corroyage à chaud de ladite préforme, avec une réduction de section d'au moins 90 % à une température de préférence comprise entre 200 °C et 400 °C. De préférence, ledit procédé d'obtention comprend, en outre, après ladite opération de corroyage, un recuit de précipitation d'au moins 8 heures à une température comprise entre 300 °C et 400 °C, et de préférence comprise entre 320 et 380 °C.

La demanderesse a constaté que l'utilisation d'un recuit de précipitation de la préforme après l'opération de corroyage, et non avant corroyage, permet d'augmenter sensiblement le couple RRR/propriétés mécaniques du stabilisateur final. La combinaison du corroyage et du recuit de précipitation permet de limiter sensiblement le temps nécessaire pour arriver à une précipitation optimale du fer et du nickel.

L'invention a aussi pour objet un procédé de fabrication d'un conducteur supraconducteur de l'invention, qui comporte au moins une opération d'insertion d'au moins une âme supxaconductrice dans un stabilisateur à partir d'une préforme selon l'invention. De préférence, ce procédé comprend en outre une opération de réduction de section du conducteur de manière à obtenir une section comprise de préférence entre 1,10 et 1,33 fois la section finale du conducteur supraconducteur, suivie d'un traitement thermique de restauration et d'une opération finale de réduction de section du conducteur, à froid, jusqu'à la section finale souhaitée.

La demanderesse a constaté que l'utilisation d'un traitement thermique de restauration dit "intermédiaire", c'est-à-dire sur une ébauche de conducteur supraconducteur ayant une section légèrement supérieure à celle du conducteur final, permet d'augmenter sensiblement les propriétés mécaniques du stabilisateur final, sans trop dégrader le RRR, d'où des compromis RRR/propriétés mécaniques optimisés et ajustables.

L'invention a aussi pour objet l'utilisation d'au moins un conducteur supraconducteur de l'invention dans un dispositif magnétique tel qu'une bobine magnétique supraconductrice.

### Description des figures

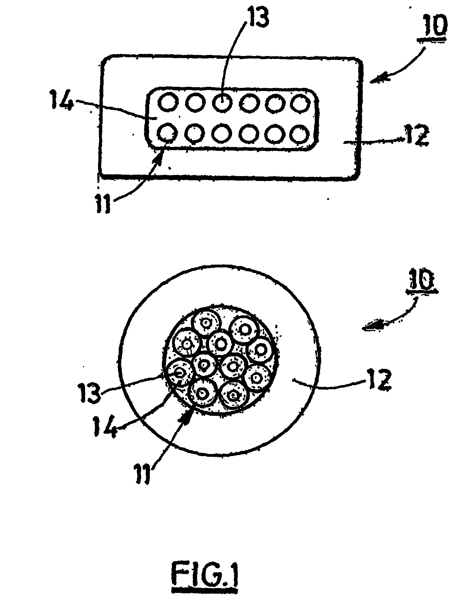

La figure 1 illustre, en section, la structure typique d'un conducteur supraconducteur selon l'invention.
La figure 2 illustre, de manière schématique, un procédé de fabrication d'un conducteur supraconducteur selon l'invention.
La figure 3 représente de manière graphique des valeurs de RRR (figure 3a) et de limite élastique (figure 3b) obtenues sur des préformes selon l'invention.

### Description détaillée de l'invention

Le conducteur supraconducteur (10) selon l'invention comporte au moins une âme supraconductrice (11) et un stabilisateur cryogénique à base d'aluminium (12), et est caractérisé en ce que le stabilisateur (12) est constitué, en tout ou partie, d'un alliage d'aluminium de haute pureté, dit Al-Fe-Ni, de composition :
200 ppm ≤ Fe + Ni ≤ 1500 ppm ;
0,20 ≤ Fe / (Fe + Ni) ≤ 0,65 ;
optionnellement B < 100 ppm ;
la somme des teneurs en impuretés inévitables autres que Fe, Ni et B < 0,01 % ; reste aluminium.

Chaque âme supraconductrice (11) est typiquement constituée d'un ou plusieurs filament(s) supraconducteur(s) (13) de faible section unitaire (typiquement ⌀ < 50 µm) et d'une matrice (14) en cuivre ou alliage de cuivre de haute pureté ou en aluminium ou alliage d'aluminium de haute pureté.

De préférence, la teneur totale Fe + Ni est inférieure ou égale à 1200 ppm (c'est-à-dire : 200 ppm ≤ Fe + Ni ≤ 1200 ppm).

De préférence, les impuretés inévitables dudit alliage comprennent moins de 10 ppm de silicium (Si) et moins de 5 ppm de manganèse (Mn). La teneur en silicium et en manganèse dudit alliage Al-Fe-Ni de haute pureté est de préférence limitée aux valeurs ci-dessus car ces éléments ont tendance à rester en solution solide dans l'aluminium et à dégrader le RRR sans améliorer les propriétés mécaniques.

Ledit alliage d'aluminium Al-Fe-Ni de haute pureté peut éventuellement contenir, en outre, en tant qu'élément d'alliage, jusqu'à 100 ppm de bore (B), c'est-à-dire que la teneur pondérale en bore est inférieure à 100 ppm. La présence de bore (B) permet d'éviter les risques de chute de la conductivité électrique au cas où l'aluminium de base utilisé contiendrait des impuretés telles que le titane (Ti), le vanadium (V) ou le zirconium (Zr), qui sont normalement absents des nuances 5N, mais qui peuvent être présents dans les bases 4N. Le bore fait précipiter ces éléments par réaction physico-chimique avec eux. Lorsque ces éléments sont présents en quantité notable (plus de 2 ppm au total, par exemple), la teneur en bore est alors de préférence au moins égale à 20 ppm (c'est-à-dire que la teneur en bore dudit alliage est de préférence comprise entre 20 et 100 ppm) afin d'assurer leur précipitation sous forme de borures lors des traitements thermiques de l'alliage. Ces borures dégradent beaucoup moins la conductivité que les éléments indésirables en solution solide.

La teneur souhaitée en bore peut être obtenue par addition d'un alliage mère au bore (tel qu'un AB4) à une base aluminium de haute pureté, ou d'un sel comportant du bore réductible par l'aluminium liquide, tel que le fluoborate de potassium.

La somme des impuretés inévitables autres que Fe, Ni et B dudit alliage est de préférence inférieure à 0,005 %, et de préférence encore inférieure à 0,001 %, ce qui permet d'éviter la présence, parmi les impuretés inévitables, d'éléments qui n'auraient pas d'effet favorable sur les propriétés mécaniques, mais qui risqueraient de dégrader légèrement les propriétés électriques.

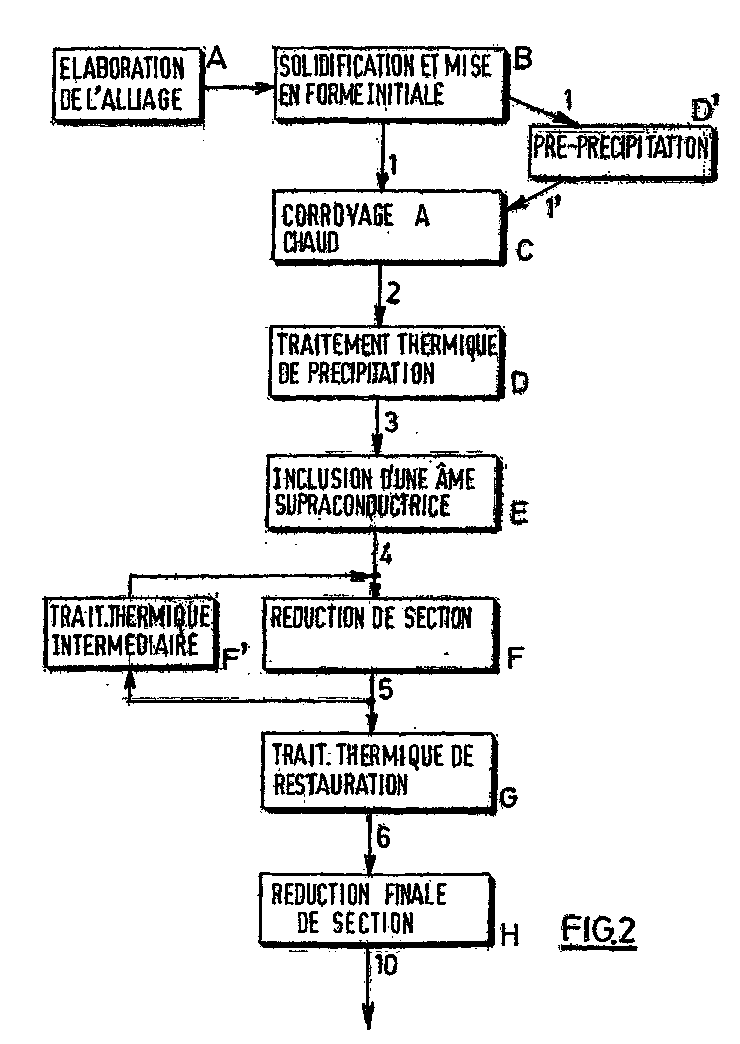

De préférence, une grande partie du fer et du nickel présents dans ledit alliage d'aluminium Al-Fe-Ni de haute pureté selon l'invention se trouve sous forme de fines particules intermétalliques (dont la taille est typiquement inférieure à 1 µm). Plus précisément, la quantité totale des éléments d'alliage Fe et Ni en solution solide dans l'aluminium dudit alliage est inférieure à 20 ppm (le reste de ces éléments étant "précipité" sous forme de particules intermétalliques). Lesdites particules se forment en partie pendant la solidification de l'alliage sous forme de particules relativement grossières (environ 3 µm à 20 µm). Un traitement thermique dit de précipitation (étape D de la figure 2) permet de former un nombre important de particules fines, c'est-à-dire de taille inférieure à environ 1 µm (également appelés "précipités fins"), à partir des éléments d'alliage restés en solution solide après l'opération de solidification de l'alliage liquide, ce qui a un impact favorable sur les propriétés mécaniques. Ledit traitement consiste à chauffer le produit à une température typiquement comprise entre 300 et 400 °C, pendant une durée qui dépend de la température de traitement et qui est d'au moins 8 heures (la durée est d'autant plus longue que la température est basse). Le corroyage préalable favorise, quant à lui, la dispersion des sites de précipitation desdits précipités fins, ce qui a également un effet très favorable sur les propriétés mécaniques du produit.

La préforme de stabilisateur cryogénique (1, 2, 3) selon l'invention est caractérisée en ce qu'elle est constituée, en tout ou partie, dudit alliage d'aluminium Al-Fe-Ni de haute pureté. Ladite préforme (1, 2, 3) est destinée à la fabrication d'un conducteur supraconducteur notamment par co-extrusion en continu de la préforme et de l'âme supraconductrice. Ladite co-extrusion peut notamment être effectuée selon le procédé dit "conforme", qui est connu sous le nom de marque "CONFORM ®" (de la Société Holton Machinery Ltd) et qui est décrit, par exemple, dans le brevet américain US 4 564 347 (correspondant à la demande européenne EP 125 788). Le procédé conforme est un procédé d'extrusion continue par une machine rotative, généralement à gorge(s). Ce procédé permet l'insertion en continu d'une âme (d'une première composition) dans une préforme (d'une deuxième composition et généralement sous forme de fil de section circulaire ou rectangulaire) qui est placée sur une roue en rotation comportant au moins une gorge et un sabot et qui est entraînée par ladite roue vers une "chambre d'insertion" dans laquelle l'âme est insérée dans la préforme. Le sabot est une pièce venant s'insérer dans la gorge et permettant de modifier la forme finale de la préforme par pression. Le procédé entraîne un échauffement de la préforme et de l'âme, à une température typiquement de l'ordre de 300 à 400 °C, qui est d'une durée très courte (quelques secondes), de sorte que l'état de précipitation métallurgique de l'âme et de la préforme ne sont pas modifiées de manière significative par le procédé conforme.

Le conducteur supraconducteur peut également être produit par fourrage d'une préforme creuse. La préforme se présente typiquement sous la forme d'un fil, d'une barre ou d'une barre creuse.

La préforme selon l'invention a, de préférence, subi une opération de corroyage à chaud (étape C de la figure 2), à une température typiquement comprise entre 200 et 400 °C, conduisant à une réduction de section d'un facteur au moins égal à 10. Cette opération de corroyage est avantageusement suivie d'un traitement thermique de précipitation (étape D de la figure 2), qui comporte de préférence un recuit d'au moins 8 heures à une température comprise entre 300 °C et 400 °C.

L'alliage de haute pureté Al-Fe-Ni selon l'invention peut être obtenu par ajout des éléments dits "d'addition" ou "d'alliage" (Fe, Ni), dans les proportions souhaitées, à une "base aluminium" de pureté supérieure à 4N, c'est-à-dire à une base aluminium dont la teneur en éléments autres que l'aluminium (mais incluant le fer et les impuretés inévitables) est inférieure à 0,01 % en poids. Lesdits éléments d'addition sont typiquement ajoutés sous forme d'alliage mère ou de métaux purs, ou éventuellement d'un sel pour le cas du bore (par exemple, du fluoborate de potassium, qui est réduit par l'aluminium liquide en libérant le bore).

La demanderesse a remarqué que, de manière inattendue, il est suffisant d'utiliser une base aluminium de pureté comprise entre 99,99 % et 99,999 %, alors que l'art antérieur enseigne d'utiliser des bases aluminium de pureté au moins égale à 99,999 % et contenant, en particulier, de très faibles teneurs en Fe, qui est un élément considérée comme particulièrement nuisible selon l'enseignement de l'art antérieur. En d'autres termes, la composition dudit alliage Al-Fe-Ni de haute pureté utilisé selon l'invention peut contenir une teneur totale en impuretés inévitables supérieure à 0,001 %, et pouvant aller jusqu'à 0,01 %, mais les propriétés mécaniques et électriques sont aussi bonnes avec une base aluminium contenant moins de 0,001 % d'impuretés.

L'invention a aussi pour objet un procédé d'obtention d'une préforme (1, 2, 3) de stabilisateur cryogénique qui permet de co-précipiter la quasi-totalité des éléments d'alliage. Ce procédé est caractérisé en ce qu'il comprend un traitement de précipitation sur le produit corroyé (tel que par extrusion) avant la mise en forme finale.

Plus précisément, le procédé d'obtention d'une préforme de stabilisateur cryogénique selon l'invention est caractérisé en ce qu'il comporte :
- la préparation (ou élaboration) par fusion et mise au titre d'un alliage d'aluminium ayant la composition dudit alliage Al-Fe-Ni de haute pureté de l'invention (étape A de la figure 2);
- la formation d'une préforme brute (1) par solidification et mise en forme dudit alliage, de préférence sous forme d'un produit allongé de section droite sensiblement constante (étape B de la figure 2).

Lesdites solidification et mise en forme (étape B) peuvent être effectuées par coulée continue (de manière à former, par exemple, du fil) ou semi-continue (de manière à former par exemple une billette) ou par moulage.

Dans le mode de réalisation préféré de l'invention, ce procédé comporte en outre une opération de corroyage à chaud de la préforme brute (1) (étape C de la figure 2), avec une réduction de la section droite d'au moins 90 % (qui produit une préfonne dite corroyée (2)). L'opération de corroyage (étape C) peut être effectuée en une ou plusieurs étapes dites "passes". La température de corroyage est de préférence typiquement comprise entre 200 et 400 °C. Ce corroyage est typiquement réalisé par extrusion ou par laminage. Dans le cas de la coulée continue de fil avec laminage en continu, les dernières passes de laminage se font de préférence à une température inférieure à 400 °C. Une température de corroyage à une température inférieure à 400 °C favorise la formation, pendant le corroyage, de germes très fins de précipités intermétalliques, à partir des éléments d'alliage restés en solution solide dans l'aluminium.

L'opération de corroyage à chaud (étape C) est de préférence suivie d'un traitement thermique de précipitation (étape D) de la préforme (2), de manière à entraîner la précipitation des éléments d'alliage (Fe, Ni et, le cas échéant, B). Ce traitement est de préférence effectué à une température comprise entre 300 et 400 °C, pendant une durée supérieure à 8 heures environ. Cette durée est d'autant plus longue que la température est basse et est d'autant plus courte que le corroyage préalable a été important (un corroyage important multiplie le nombre de germes de précipitation pour les éléments d'alliage).

La demanderesse a constaté que l'opération de corroyage (C) et le traitement thermique (D) permettaient l'obtention d'un RRR très élevé avec des temps de traitement qui restent acceptables sur le plan industriel, à savoir typiquement quelques heures, voire quelques jours, plutôt que quelques semaines.

Il est possible de réaliser un traitement thermique préalable, dit de "pré-précipitation", (D') sur la préforme brute de coulée (1) et avant l'opération de corroyage (C) de la préforme (1').

Selon un autre mode de réalisation préféré de l'invention, l'alliage au titre en fusion est coulé en continu sous forme de barre (1) dans un roue à gorge en rotation et refroidie (B), cette barre (1) étant ensuite laminée en continu et à chaud dans un laminoir multicages (C), avec une réduction de section d'au moins 90 % en plusieurs passes (les dernières passes se faisant de préférence à une température inférieure à 400 °C), de manière à produire une préforme (2) ayant la forme d'un fil de section sensiblement circulaire. Le fil ainsi obtenu est de très grande longueur, à savoir typiquement plusieurs kilomètres. Ce fil (2) est ensuite soumis à un traitement thermique de précipitation des éléments d'alliage (D), à une température comprise entre environ 300 et 400 °C.

L'invention a aussi pour objet un procédé de fabrication du conducteur supraconducteur. De préférence, ce procédé comporte au moins une opération d'insertion d'un corps supraconducteur dans le stabilisateur (étape E) et est caractérisé en ce qu'il comporte la fourniture d'une préforme de stabilisateur cryogénique selon l'invention ou la fabrication de celle-ci par le procédé d'obtention de l'invention. Chaque opération d'insertion (E) peut être effectuée selon le procédé conforme (CONFORM ®) ou par fourrage de la préforme.

Le procédé comporte typiquement un co-filage (étape E) d'une ébauche (3, 4) comportant un matériau supraconducteur (généralement une âme supraconductrice (11) formée de filaments fins d'alliage supraconducteur enrobé dans une matrice de cuivre) et une gaine périphérique (ledit stabilisateur cryogénique (12)) comportant, en tout ou partie, un alliage d'aluminium Al-Fe-Ni de haute pureté selon l'invention. Selon une première variante, ladite ébauche peut être produite par filage d'une barre creuse en alliage d'aluminium Al-Fe-Ni de haute pureté selon l'invention et fourrage de l'intérieur de la barre avec le matériau supraconducteur de manière à former une âme centrale. Selon une autre variante préférée de l'invention, ladite ébauche (3) peut être produite selon le procédé conforme (CONFORM ®).

Le procédé de fabrication comporte en général au moins une opération (étape F) de réduction de section du conducteur (4) produit par ladite au moins une opération d'insertion (E). Lorsque le procédé de fabrication comprend plusieurs opérations de réduction de sections, il est généralement avantageux d'effectuer des traitements thermiques intermédiaires (F') entre les opérations de réduction (F), de façon à restaurer lorsque nécessaire une capacité d'allongement suffisante à l'alliage qui a été écroui par les passes précédentes.

Le procédé de fabrication selon l'invention est caractérisé en ce que, avant les dernières passes de mise en forme du conducteur supraconducteur (5) (étape F), c'est-à-dire avant réduction finale à froid de la section d'environ 10 à 25 % (correspondant à un allongement de 10 à 33 % environ), on effectue un traitement thermique de restauration (étape G), afin d'éviter la rupture du stabilisateur lors du corroyage final, tout en évitant de diminuer de manière irréversible la limite élastique. De préférence, ce traitement est effectué, pendant environ 1 heure, à une température comprise entre environ 150 et 350 °C et, le cas échéant, inférieure à celle du traitement de précipitation (D) effectué antérieurement sur la préforme (2) après l'opération de corroyage, de sorte qu'elle est suffisamment élevée pour redonner à l'alliage écroui une capacité d'allongement suffisante, et suffisamment faible pour éviter un grossissement important du grain de l'alliage et une remise en solution des éléments d'alliage déjà précipités lors du traitement de précipitation (D).

Le procédé de fabrication du conducteur supraconducteur selon la variante préférée l'invention est caractérisé en ce qu'il comprend l'insertion (E), en continu, d'au moins une âme supraconductrice dans une préforme de stabilisateur (3) en alliage Al-Fe-Ni de haute pureté selon l'invention, de manière à obtenir un conducteur composite brut (4) (ou "ébauche de conducteur supraconducteur") constitué d'au moins une âme supraconductrice gainée par un stabilisateur cryogénique en alliage d'aluminium Al-Fe-Ni de haute pureté, ladite opération d'insertion (E) étant suivie d'une ou plusieurs réductions de section intermédiaires (F), éventuellement séparées par des recuits de restauration de la capacité d'allongement (F'), jusqu'à ce que la section obtenue représente 1,10 à 1,33 fois la section finale désirée, et d'une restauration de la capacité d'allongement suivie d'une réduction finale de section, à froid, (H) par extrusion, tréfilage ou laminage, jusqu'à la section finale souhaitée.

Ainsi, selon l'invention, il est particulièrement avantageux d'effectuer :
- une opération (F) de réduction de section de l'ébauche de conducteur (4) de manière à obtenir une ébauche intermédiaire (5) dont la section est comprise entre 1,10 et 1,33 fois la section finale dudit conducteur supraconducteur (10), en fonction du compromis souhaité entre RRR et propriétés mécaniques finales ;
- suivie d'un traitement thermique de restauration (G) de ladite ébauche intermédiaire (5), qui produit une ébauche dite "restaurée" (6) ;
- suivie d'une opération de réduction de section finale (H), à froid, de ladite ébauche restaurée (6) de manière à obtenir un conducteur supraconducteur (10) ayant ladite section finale.

### Exemples

### Exemple 1

Des essais ont été réalisés sur 5 alliages (E1 à E5) dans les conditions décrites ci-dessous. Ces alliages, dont la composition est donnée dans le tableau 1, ont été élaborés et coulés en billettes cylindriques de diamètre 115 mm par solidification directionnelle verticale en moule, avec une vitesse de solidification de 20 à 50 mm/minute. La base métal était un aluminium raffiné par raffinage électrolytique selon le procédé dit "3 couches", de pureté dite "4N", contenant de 3 à 12 ppm de Fe, de 2 à 4 ppm de Si, de 2 à 3 ppm de Cu, de 2 à 5 ppm de Zn, de 1 à 4 ppm de Mg et jusqu'à 10 ppm au total d'autres impuretés diverses (dont 2 à 3 ppm de phosphore (P) et 1 à 2 ppm de terres rares, la teneur en chacun des éléments Ti, V et Zr étant inférieure à 1 ppm).

**Tableau 1**

| | Composition [ppm en poids] | | | | | |
|---|---|---|---|---|---|---|
| Alliage | Fe | Ni | Si | Cu | Zn | Mg |
| E1 | 100 | 100 | 4 | 3 | 3 | 3 |
| E2 | 200 | 200 | 2 | 2 | 2 | 2 |
| E3 | 400 | 400 | 3 | 3 | 5 | 4 |
| E4 | 250 | 400 | 4 | 3 | 3 | 3 |
| E5 | 400 | 250 | 3 | 2 | 2 | 1 |

Sur les billettes brutes de coulée, on a prélevé des échantillons cylindriques de 20 mm de diamètre et de 40 mm de longueur, dont on a mesuré la résistivité dans l'hélium liquide à 4,2 K par une méthode inductive.

Par ailleurs, un tronçon de chaque billette a été homogénéisé pendant 24 heures à 500 °C, et on a prélevé des échantillons de mêmes dimensions que ci-dessus pour mesurer la résistivité de l'alliage après traitement d'homogénéisation.

Enfin, sur les billettes non homogénéisées (brutes de coulées), on a prélevé un autre tronçon sur lequel on a pratiqué un traitement de précipitation de 24 heures à 420 °C, suivi d'un traitement thermique de 144 heures à 370 °C. La résistivité de ces billettes a ensuite été mesurée dans les mêmes conditions que ci-dessus.

**Tableau 2**

| | Brute de coulée | | Homogénéisée (24 h à 500 °C) | | Recuit (24 h à 420 °C + 144 h à 370 °C) | |
|---|---|---|---|---|---|---|
| Alliage | ρ(4,2 K) [nΩ.cm] | RRR | ρ(4,2K) [nΩ.cm] | RRR | ρ(4,2K) [nΩ.cm] | RRR |
| E1 | 16,08 | 175 | 10,71 | 262 | 4,45 | 628 |
| E2 | 20,76 | 135 | 10,11 | 277 | 5,04 | 555 |
| E3 | 22,68 | 124 | 9,64 | 290 | 7,72 | 362 |
| E4 | 18,76 | 150 | 9,61 | 291 | 6,05 | 462 |
| E5 | 23,08 | 122 | 11,39 | 246 | 8,32 | 336 |

Le tableau 2 donne les résultats obtenus, lesquels sont exprimés en nΩ.cm à 4,2 K et en RRR. Le RRR correspond au rapport entre la résistivité à 300 K (symbolisé par ρ(300 K)) sur la résistivité mesurée à 4,2 K (symbolisé par ρ(4,2 K)) et a été calculé en utilisant la relation : (2790 + ρ(4,2 K))/ρ(4,2 K), où ρ(4,2 K) est exprimée en nΩ.cm et la valeur de 2790 nΩ.cm est la composante thermique, à 300 K, de la résistivité d'un aluminium ultrapur ayant une résistivité résiduelle à 4,2 K inférieure à 0,1 nΩ.cm.

On constate que les traitements thermiques d'homogénéisation, ou de recuit de précipitation de durée industriellement acceptable, n'améliorent que modérément la résistivité des produits bruts de coulée. Ces traitements, préconisés la demande WO 00/17890, sont donc peu opérants pour ces alliages ternaires contenant du fer.

Sur chaque coulée, on a alors prélevé un tronçon brut de coulée de 150 mm de longueur, que l'on a écrouté pour enlever la zone périphérique, ramenant ainsi le diamètre de 115 mm à 100 mm. Ces tronçons ont été portés à 370 °C pendant 4 heures, puis filés à la presse à la même température pour obtenir des ébauches de fil de 10 mm de diamètre, ce qui représente une réduction de section de 99 %. On les a ensuite laissé refroidir naturellement à l'air, leur température étant redescendue à moins de 50 °C en 10 minutes environ.

Des échantillons ont été prélevés sur chaque alliage afin de mesurer la résistivité et les propriétés mécaniques à l'état brut de filage à chaud, c'est-à-dire sur des ébauches de ⌀ 10 mm filées à la presse à 370 °C. Les mesures ont été faites à la température ambiante. D'autres échantillons on subi un recuit de précipitation de 168 heures à 375 °C, et l'on a mesuré les propriétés mécaniques et la résistivité après ce traitement thermique complémentaire. Le tableau 3 regroupe les résultats obtenus, pour la limite élastique (L.E) à 0,2 % d'allongement et pour le RRR.

On constate que le traitement de recuit de précipitation est beaucoup plus efficace sur ébauche filée à la presse que sur la billette brute de coulée, mais l'amélioration très sensible du RRR est accompagnée d'une dégradation considérable des propriétés mécaniques (notamment de la limite élastique à 0,2 % d'allongement).

On constate également que, de façon surprenante, l'amélioration du RRR est plus faible pour l'alliage E1 le moins chargé en éléments d'addition. A titre de simple tentative d'explication, on peut penser que ce constat inattendu pourrait provenir de ce que, dans les alliages trop peu chargés en éléments d'addition, il est plus difficile de créer suffisamment de germes de précipités pour collecter rapidement les éléments d'addition restés en solution sursaturée dans la masse du métal.

**Tableau 3**

| | Brut de filage | | Après recuit de précipitation | |
|---|---|---|---|---|
| Alliage | L.E à 0,2 % [MPa] | RRR | L.E à 0,2 % [MPa] | RRR |
| E1 | 29 | 291 | 15 | 680 |
| E2 | 35 | 260 | 18 | 910 |
| E3 | 37 | 210 | 21 | 825 |
| E4 | 36 | 250 | 19 | 890 |
| E5 | 33 | 240 | 18 | 805 |

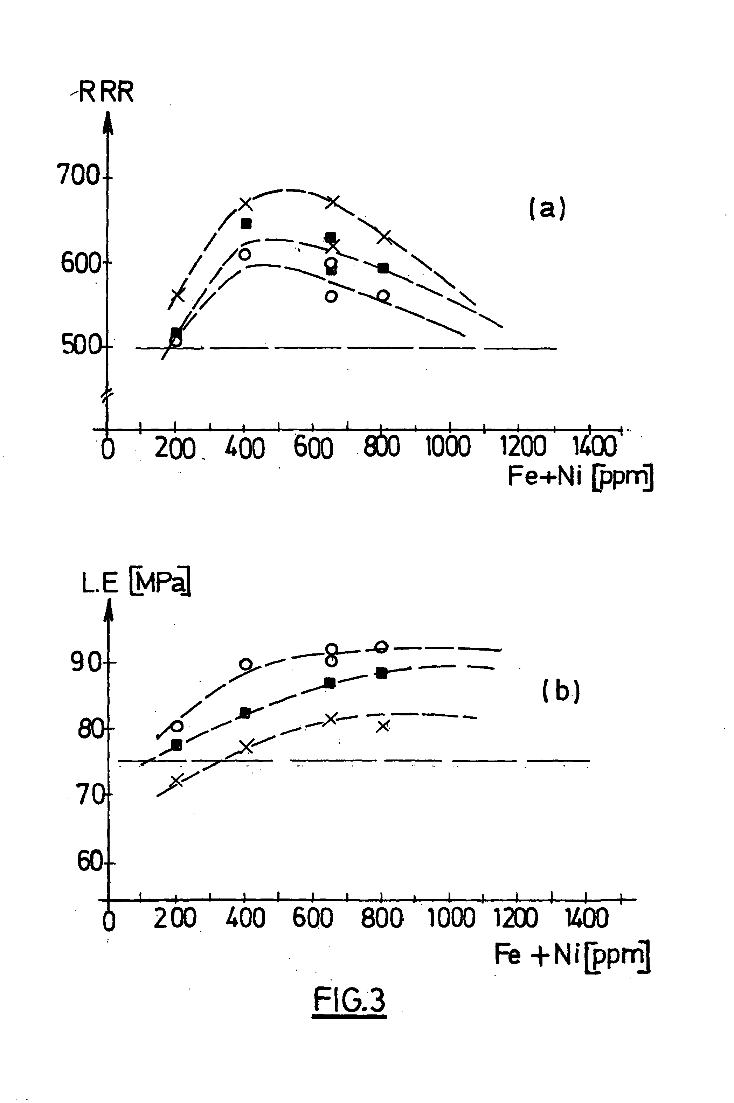

Enfin, des échantillons d'ébauche de fil de 10 mm de diamètre ayant subi le recuit de précipitation précédent ont subi un étirage par traction à froid, en vue de juger de l'évolution de leur résistivité et de leur limite élastique après un tel traitement de corroyage à froid (qui entraîne un durcissement par déformation). Les échantillons ont subi des allongements de 10, 15, 20 et 25 %, correspondant à des réductions de section de 0, 9, 13, 16,7 et 20 %. Les propriétés mécaniques et les RRR ont ensuite été mesurés sur ces échantillons tractionnés à froid. Le tableau 4 regroupe les résultats obtenus. La figure 3 représente les résultats obtenus pour une réduction de section à froid de 13 % (×), 16,7 % (■) et 20 % (○) (les traits hachurés ont été ajoutés afin de guider l'oeil).

On constate donc que les alliages ainsi choisis, et relativement peu chargés en éléments d'addition (< 1000 ppm total), ayant subi les traitements de réduction de section et de recuit de précipitation indiqués, permettent d'obtenir, par une réduction finale de section pratiquée à froid relativement limitée, des couples RRR/limite élastique tout à fait exceptionnels, tels que : RRR > 650 et L.E > 80 MPa à température ambiante, RRR > 600 et L.E > 85 MPa à température ambiante, ou RRR > 550 et L.E > 90 MPa à température ambiante, par un choix adapté du taux de la réduction finale de section, à froid. Il est en outre notable que ces performances puissent être atteintes pour une large gamme de compositions (compositions E2, E3, E4 et E5), la composition E1 ne se situant qu'un peu en retrait. En particulier, l'efficacité démontrée du traitement de précipitation sur préforme corroyée à chaud, et les faibles différences de RRR et de propriétés mécaniques entre les nuances comportant 400 ppm [Fe + Ni], 650 ppm [Fe + Ni] et 800 ppm [Fe + Ni] laisse à penser que l'on peut, sans inconvénient, monter sensiblement la teneur totale (Fe + Ni] jusqu'à 1200 ppm, voir 1500 ppm.

**Tableau 4**

| | Alliage | Réduction de section à froid | | | | |
|---|---|---|---|---|---|---|
| | | 0 % | 9 % | 13 % | 16,7 % | 20 % |
| E1 | L.E 0,2 % [MPa] RRR | 15 680 | 62 585 | 72 560 | **77 515** | **81 506** |
| E2 | L.E 0,2 % [MPa] RRR | 18 910. | 66 715 | **77 670** | **83 645** | **90 610** |
| E3 | L.E 0,2 % [MPa] RRR | 21 825 | 70 660 | **81 630** | **88 595** | **93 560** |
| E4 | L.E 0,2 % [MPa] RRR | 19 890 | 73 700 | **82 670** | **87 630** | **92 600** |
| E5 | L.E 0,2 % [MPa] RRR | 18 805 | 72 660 | **82 620** | **87 590** | **91 560** |

De tels résultats n'avaient pu, à notre connaissance, être obtenus avec des alliages binaires du type Al-Ni (ou plus encore Al-Fe), même plus chargés en éléments d'addition.

### Exemple 2

Les mêmes essais ont été refaits, dans les mêmes conditions, sur l'alliage de formulation E4 (250 ppm Fe et 400 ppm Ni), mais en utilisant un aluminium de base comportant des teneurs plus fortes en titane (5 ppm) et en vanadium (2 ppm).

Un échantillon n'a pas été soumis au traitement complémentaire au bore (c'est-à-dire qu'il ne contenait pas d'addition de bore) ; un autre a été élaboré avec addition de 20 ppm de bore, qui a été ajouté sous forme d'alliage-mère à 4 % en poids de B. Après filage à chaud et recuit de précipitation, on a observé les RRR suivants :
- alliage non traité au bore : RRR = 600 ;
- alliage traité au bore : RRR = 900.

Ces résultats montrent donc une très grande efficacité de l'addition de bore dès que des éléments tels que le titane sont présents, même en faible quantité, dans l'aluminium de base. Des additions de bore en quantités plus importantes sont possibles sans réduire résistivité de façon significative car le bore est très peu soluble dans l'aluminium solide et le bore en excès précipite sous forme de borure d'aluminium AlB₂ dont l'effet sur la résistivité est très faible. Des additions plus fortes de bore peuvent favoriser une précipitation encore plus complète des éléments Ti, V et Zr très néfastes pour la conductivité électrique.

### Exemple 3

Cet essai correspond à un production semi-industrielle.

On a élaboré, dans un four en alumine très pure, 500 kg d'un alliage dont la teneur en Fe et Ni était : Fe = 259 ± 2 ppm et Ni = 438 ± 3 ppm, d'où Fe + Ni = 697 ppm et Fe/(Fe + Ni) = 0,37. La teneur totale en impuretés inévitables, c'est-à-dire en éléments autres que Fe et Ni, était de 15 ppm environ, dont notamment : Si = 3,6 ± 0,3 ppm ; Cu = 1,5 ± 0,2 ppm ; Zn = 1,9 ± 0,3 ppm et Mg = 0,2 ± 0,1 ppm.

Cet alliage a été coulé par coulée semi-continue verticale, à une vitesse de 140 mm/min, en billettes de diamètre 148 mm.

Des examens de la structure de coulée ont été pratiqués, par microscopie électronique à balayage, sur des tranches de ces billettes, qui ont révélé la présence d'une faible densité de précipités en forme de "roses des sables" contenant simultanément du fer, du nickel et de l'aluminium, en proportions compatibles avec des précipités intermétalliques de formule Al₉FeₓNi₂₋ₓ. Ces précipités avaient une taille de l'ordre de 3 µm à 20 µm.

On a également mesuré le RRR de l'alliage à l'état brut de coulée et trouvé des valeurs comprises entre 275 et 315 (avec une valeur moyenne de 290).

Sur un tronçon de billette, on a pratiqué un recuit de précipitation de 24 heures à 420 °C. Après ce recuit, le RRR mesuré s'est établi entre 390 et 415 (avec une valeur moyenne de 400), ce qui montre que l'efficacité de ce recuit, pour précipiter le reste du fer et du nickel resté en solution solide, a été très limitée, contrairement aux enseignements de la demande WO 00/17890 pour les alliages binaires Al (5N) + Ni.

On a écrouté à ⌀ 140 mm un autre tronçon de 600 mm de long, non recuit, que l'on a réchauffé à 370 °C, puis extrudé à cette température en un fil de ⌀ 9,5 mm (correspondant à une réduction de section d'un facteur 217) apte à l'utilisation dans le procédé conforme (CONFORM ®). On a mesuré le RRR (300 K / 4,2 K), et les propriétés mécaniques à température ambiante, à l'état brut de filage.

La bobine ainsi obtenue a ensuite été soumise à un traitement de recuit de 48 heures à 350 °C. Le RRR (300 K / 4,2 K), et les propriétés mécaniques à température ambiante, ont à nouveau été mesurés.

Enfin, des échantillons de ce fil ayant subi le recuit de précipitation ont été corroyés à froid, avec une réduction de section de 16,7 % (correspondant à un allongement de 20 %). Les propriétés mécaniques de ce fil corroyé ont également été mesurées, toujours à température ambiante, ainsi que le RRR (300 K / 4,2 K).

Les résultats obtenus sont regroupés dans le tableau 5 suivant :

**Tableau 5**

| | RRR | L.E 0,2 % [MPa] |
|---|---|---|
| Brut de filage à 370 °C | 340 | **34** |
| Après recuit de 48 h à 350 °C | 950 | **18** |
| Après corroyage à froid | 650 | **88** |

Ces résultats montrent l'effet technique particulièrement avantageux du procédé de l'invention sur les caractéristiques électriques et mécaniques du-stabilisateur à base d'aluminium de l'invention.

### Avantages de l'invention

Les propriétés électriques et mécaniques du conducteur supraconducteur comportant un stabilisateur en alliage Al-Fe-Ni de haute pureté selon l'invention peuvent être facilement ajustées à des valeurs très élevées non atteintes par les conducteurs de l'art antérieur, ce qui assure une très grande fiabilité pour leur utilisation dans des conditions difficiles. Les conducteurs selon l'invention présentent en particulier des propriétés électriques et mécaniques équivalentes, voire supérieures, à celles des conducteurs comportant un stabilisateur à base de cuivre, ce qui permet d'envisager des gains de poids importants (plus de 50 %) sur les bobinages supraconducteurs (par exemple pour IRMN), avec un coût sensiblement plus faible grâce à l'utilisation d'une base aluminium 4N, moins coûteuse que les bases aluminium 5N et nettement moins coûteuse que le cuivre.

L'invention présente également l'avantage de permettre, à limite élastique minimum imposée pour une application donnée, d'obtenir un RRR plus élevé que l'art antérieur, ce qui signifie que, pour des propriétés mécaniques égales, les conductivités électrique et thermique seront plus élevées. Par conséquent, il est possible d'envisager de diminuer le rapport entre la section du gainage stabilisateur et celle de l'âme (ou des âmes) supraconductrice(s), ce qui se traduit pour une bobine supraconductrice par une compacité plus grande et un allégement supplémentaire, à propriétés magnétiques inchangées, et par un coût de gainage stabilisateur plus faible. Cet allégement et cette compacité facilitent également le refroidissement jusqu'à 4,2 K et le maintien ultérieur à cette température, ce qui réduit le coût d'utilisation, notamment par une moins grande consommation d'hélium liquide. Typiquement, une augmentation de 20 % du RRR permet d'envisager une réduction de 10 % de la section du gainage stabilisateur.

## Revendications

1. Conducteur supraconducteur comportant au moins une âme supraconductrice et un stabilisateur cryogénique à base d'aluminium **caractérisé en ce que** ledit stabilisateur est constitué, en tout ou partie, d'un alliage d'aluminium de haute pureté, dit "Al-Fe-Ni", de composition :
200 ppm ≤ Fe + Ni ≤ 1500 ppm ;
0,20 ≤ Fe / (Fe + Ni) ≤ 0,65 ;
optionnellement, B < 100 ppm ;
la somme des teneurs en impuretés inévitables autres que Fe, Ni et B < 0,01 % ; reste aluminium.

2. Conducteur supraconducteur selon la revendication 1, **caractérisé en ce que** teneur totale Fe + Ni est inférieure ou égale à 1200 ppm.

3. Conducteur supraconducteur selon la revendication 1 ou 2, **caractérisé en ce que** les impuretés inévitables dudit alliage comprennent moins de 10 ppm de Si et moins de 5 ppm de Mn.

4. Conducteur supraconducteur selon l'une quelconque des revendications 1 à 3, **caractérisé en ce que** la somme des teneurs en impuretés inévitables autres que Fe, Ni et B dudit alliage est inférieure à 0,005 %.

5. Conducteur supraconducteur selon l'une quelconque des revendications 1 à 3, **caractérisé en ce que** la somme des teneurs en impuretés inévitables autres que Fe, Ni et B dudit alliage est inférieure à 0,001 %.

6. Conducteur supraconducteur selon l'une quelconque des revendications 1 à 5, **caractérisé en ce que** ledit alliage comprend entre 20 et 100 ppm de bore.

7. Conducteur supraconducteur selon l'une quelconque des revendications 1 à 6, **caractérisé en ce que** la quantité totale en Fe et Ni en solution solide dans l'aluminium dudit alliage est inférieure à 20 ppm.

8. Conducteur supraconducteur selon l'une quelconque des revendications 1 à 7, **caractérisé en ce qu'**il se présente sous forme de fil ou de câble.

9. Préforme de stabilisateur cryogénique, **caractérisée en ce qu'**elle est constituée, en tout ou partie, d'un alliage d'aluminium Al-Fe-Ni de haute pureté de composition :
200 ppm ≤ Fe + Ni ≤ 1500 ppm ;
0,20 ≤ Fe / (Fe + Ni) ≤ 0,65 ;
optionnellement, B < 100 ppm ;
la somme des teneurs en impuretés inévitables autres que Fe, Ni et B < 0,01 % ; reste aluminium.

10. Préforme selon la revendication 9, **caractérisée en ce que** teneur totale Fe + Ni est inférieure ou égale à 1200 ppm.

11. Préforme selon la revendication 9 ou 10, **caractérisée en ce que** les impuretés inévitables dudit alliage comprennent moins de 10 ppm de Si et moins de 5 ppm de Mn.

12. Préforme selon l'une quelconque des revendications 9 à 11, **caractérisée en ce que** la somme des teneurs en impuretés inévitables autres que Fe, Ni et B dudit alliage est inférieure à 0,005 %.

13. Préforme selon l'une quelconque des revendications 9 à 11, **caractérisé en ce que** la somme des teneurs en impuretés inévitables autres que Fe, Ni et B dudit alliage est inférieure à 0,001 %.

14. Préforme selon l'une quelconque des revendications 9 à 13, **caractérisée en ce que** ledit alliage comprend entre 20 et 100 ppm de bore.

15. Préforme selon l'une quelconque des revendications 9 à 14, **caractérisée en ce que** la quantité totale en Fe et Ni en solution solide dans l'aluminium dudit alliage est inférieure à 20 ppm.

16. Préforme selon l'une quelconque des revendications 9 à 15, **caractérisée en ce qu'**elle se présente sous la forme d'un fil, d'une barre ou d'une barre creuse.

17. Préforme selon l'une quelconque des revendications 9 à 16, **caractérisée en ce qu'**elle a subi une opération de corroyage à chaud conduisant à une réduction de section d'un facteur au moins égal à 10.

18. Préforme selon la revendication 17, **caractérisée en ce que** ladite opération de corroyage à chaud est effectuée à une température comprise entre 200 et 400 °C.

19. Préforme selon l'une quelconque des revendications 17 ou 18, **caractérisée en ce que**, après ladite opération de corroyage, elle a en outre subi un traitement thermique de précipitation comportant un recuit d'au moins 8 heures à une température comprise entre 300 °C et 400 °C.

20. Procédé d'obtention d'une préforme de stabilisateur cryogénique selon l'une des revendications 9 à 16, **caractérisé en ce qu'**il comporte :
- la préparation par fusion et mise au titre dudit alliage ;
- la formation d'une préforme brute par solidification et mise en forme dudit alliage, de préférence sous forme d'un produit allongé de section droite sensiblement constante.

21. Procédé selon la revendication 20, **caractérisé en ce que** lesdites solidification et mise en forme sont effectuées par coulée continue ou semi-continue ou par moulage.

22. Procédé selon la revendication 20 ou 21, **caractérisé en ce qu'**il comporte en outre une opération de corroyage à chaud de la préforme brute, avec une réduction de la section droite d'au moins 90 %.

23. Procédé selon la revendication 22, **caractérisé en ce que** l'opération de corroyage est effectuée par extrusion ou laminage.

24. Procédé selon la revendication 22 ou 23, **caractérisé en ce que** l'opération de corroyage à chaud est effectué à une température comprise entre 200 et 400 °C.

25. Procédé selon l'une quelconque des revendications 22 à 24, **caractérisé en ce que**, après l'opération de corroyage, il comprend en outre un traitement thermique de précipitation de la préforme à une température comprise entre 300 et 400 °C, pendant une durée égale à au moins 8 heures.

26. Procédé de fabrication d'un conducteur supraconducteur selon l'une quelconque des revendications 1 à 8, comportant au moins une opération d'insertion d'au moins une âme supraconductrice dans une préforme de stabilisateur cryogénique, de manière à produire une ébauche de conducteur supraconducteur, et **caractérisé en ce qu'**il comporte la fourniture d'une préforme de stabilisateur cryogénique selon l'une des revendications 9 à 19 ou la fabrication de ladite préforme suivant le procédé de l'une des revendications 20 à 25.

27. Procédé selon la revendication 26, **caractérisé en ce que** ladite au moins une opération d'insertion est effectuée selon un procédé de co-extrusion continue.

28. Procédé selon la revendication 26, **caractérisé en ce que** ladite préforme est creuse et **en ce que** ladite au moins une opération d'insertion comporte un fourrage de la préforme.

29. Procédé selon l'une quelconque des revendications 26 à 28, **caractérisé en ce qu'**il comporte au moins une opération de réduction de section de l'ébauche de conducteur produite par ladite au moins une opération d'insertion.

30. Procédé selon l'une quelconque des revendications 26 à 29, **caractérisé en ce qu'**il comporte en outre :
- une opération de réduction de section de l'ébauche de conducteur de manière à obtenir une ébauche intermédiaire dont la section est comprise entre 1,10 et 1,33 fois la section finale dudit conducteur supraconducteur ;
- suivie d'un traitement thermique de restauration de ladite ébauche intermédiaire, qui produit une ébauche dite "restaurée" ;
- suivie d'une opération de réduction de section finale, à froid, de ladite ébauche restaurée, de manière à obtenir un conducteur supraconducteur ayant ladite section finale.

31. Procédé selon la revendication 30, **caractérisé en ce que** ledit traitement thermique de restauration est effectué, pendant environ 1 heure, à une température comprise entre environ 150 et 350 °C et, le cas échéant, inférieure à celle du traitement de précipitation effectué après l'opération de corroyage de la préforme.

32. Utilisation d'au moins un conducteur supraconducteur selon l'une quelconque des revendications 1 à 8 dans un dispositif magnétique tel qu'une bobine magnétique supraconductrice.

## Patentansprüche

1. Supraleiter mit mindestens einer supraleitenden Seele und einem kryogenen Stabilisator auf Aluminiumbasis, **dadurch gekennzeichnet, dass** der Stabilisator ganz oder teilweise aus einer hochreinen, sog. Al-Fe-Ni-Legierung besteht, mit der Zusammensetzung:
200 ppm ≤ Fe + Ni ≤ 1500 ppm ;
0,20 ≤ Fe / (Fe + Ni) ≤ 0,65 ;
optional B < 100 ppm;
Summe der anderen unvermeidbaren Verunreinigungen als Fe, Ni und B < 0,01 %; Rest Aluminium.

2. Supraleiter nach Anspruch 1, **dadurch gekennzeichnet, dass** der Gesamtgehalt Fe + Ni kleiner oder gleich 1200 ppm ist.

3. Supraleiter nach Anspruch 1 oder 2, **dadurch gekennzeichnet, dass** die unvermeidbaren Verunreinigungen der Legierung weniger als 10 ppm Si und weniger als 5 ppm Mn enthalten.

4. Supraleiter nach irgendeinem der Ansprüche 1 bis 3, **dadurch gekennzeichnet, dass** die Summe der Gehalte an anderen unvermeidbaren Verunreinigungen als Fe, Ni und B der Legierung kleiner als 0,005 % ist.

5. Supraleiter nach irgendeinem der Ansprüche 1 bis 3, **dadurch gekennzeichnet, dass** die Summe der Gehalte an anderen unvermeidbaren Verunreinigungen als Fe, Ni und B der Legierung kleiner als 0,001 % ist.

6. Supraleiter nach irgendeinem der Ansprüche 1 bis 5, **dadurch gekennzeichnet, dass** die Legierung zwischen 20 und 100 ppm Bor enthält.

7. Supraleiter nach irgendeinem der Ansprüche 1 bis 6, **dadurch gekennzeichnet, dass** die Gesamtmenge an Fe und Ni in fester Lösung im Aluminium der Legierung kleiner als 20 ppm ist.

8. Supraleiter nach irgendeinem der Ansprüche 1 bis 7, **dadurch gekennzeichnet, dass** er in Form von Draht oder Kabel vorliegt.

9. Vorform des kryogenen Stabilisators, **dadurch gekennzeichnet, dass** sie ganz oder teilweise aus einer hochreinen Al-Fe-Ni-Legierung besteht mit der Zusammensetzung:
200 ppm ≤ Fe + Ni ≤ 1500 ppm;
0,20 ≤ Fe / (Fe + Ni) ≤ 0,65 ;
optional B < 100 ppm;
Summe der anderen unvermeidbaren Verunreinigungen als Fe, Ni und B < 0,01 %; Rest Aluminium.

10. Vorform nach Anspruch 9, **dadurch gekennzeichnet, dass** der Gesamtgehalt Fe + Ni kleiner oder gleich 1200 ppm ist.

11. Vorform nach Anspruch 9 oder 10, **dadurch gekennzeichnet, dass** die unvermeidbaren Verunreinigungen der Legierung weniger als 10 ppm Si und weniger als 5 ppm Mn enthalten.

12. Vorform nach irgendeinem der Ansprüche 9 bis 11, **dadurch gekennzeichnet, dass** die Summe der Gehalte an anderen unvermeidbaren Verunreinigungen als Fe, Ni und B der Legierung kleiner als 0,005 % ist.

13. Vorform nach irgendeinem der Ansprüche 9 bis 11, **dadurch gekennzeichnet, dass** die Summe der Gehalte an anderen unvermeidbaren Verunreinigungen als Fe, Ni und B der Legierung kleiner als 0,001 % ist.

14. Vorform nach irgendeinem der Ansprüche 9 bis 13, **dadurch gekennzeichnet, dass** die Legierung zwischen 20 und 100 ppm Bor enthält.

15. Vorform nach irgendeinem der Ansprüche 9 bis 14, **dadurch gekennzeichnet, dass** die Gesamtmenge an Fe und Ni in fester Lösung im Aluminium der Legierung kleiner als 20 ppm ist.

16. Vorform nach irgendeinem der Ansprüche 9 bis 15, **dadurch gekennzeichnet, dass** sie in Form eines Drahtes, einer Stange oder einer Hohlstange vorliegt.

17. Vorform nach irgendeinem der Ansprüche 9 bis 16, **dadurch gekennzeichnet, dass** sie einem Warmumformvorgang unterzogen wurde, der zu einer Querschnittsreduktion um einen Faktor mindestens gleich 10 führt.

18. Vorform nach Anspruch 17, **dadurch gekennzeichnet, dass** der Warmumformvorgang bei einer Temperatur zwischen 200 und 400°C durchgeführt wird.

19. Vorform nach irgendeinem der Ansprüche 17 oder 18, **dadurch gekennzeichnet, dass** sie nach dem Umformvorgang zusätzlich einer Warmauslagerungsbehandlung mit einer mindestens 8-stündigen Glühung bei einer Temperatur zwischen 300°C und 400°C ausgesetzt wurde.

20. Verfahren zur Herstellung einer Vorform des kryogenen Stabilisators nach einem der Ansprüche 9 bis 16, **dadurch gekennzeichnet, dass** es umfasst:
- die Herstellung durch Schmelzen und Titereinstellung der Legierung;
- die Bildung einer Rohvorform durch Härten und Formen der Legierung, vorzugsweise in Form eines länglichen Erzeugnisses mit weitgehend konstantem Querschnitt.

21. Verfahren nach Anspruch 20, **dadurch gekennzeichnet, dass** das Härten und Formen durch kontinuierlichen oder halbkontinuierlichen Strangguss oder durch Formguss durchgeführt werden.

22. Verfahren nach Anspruch 20 oder 21, **dadurch gekennzeichnet, dass** es zusätzlich einen Warmumformvorgang der Rohvorform mit einer Querschnittsreduktion von mindestens 90 % umfasst.

23. Verfahren nach Anspruch 22, **dadurch gekennzeichnet, dass** der Umformvorgang durch Extrudieren oder Walzen durchgeführt wird.

24. Verfahren nach Anspruch 22 oder 23, **dadurch gekennzeichnet, dass** der Warmumformvorgang bei einer Temperatur zwischen 200 und 400°C durchgeführt wird.

25. Verfahren nach irgendeinem der Ansprüche 22 bis 24, **dadurch gekennzeichnet, dass** es nach dem Umformvorgang zusätzlich eine Warmauslagerungsbehandlung der Vorform bei einer Temperatur zwischen 300°C und 400°C während einer Dauer von mindestens 8 Stunden umfasst.

26. Verfahren zur Herstellung eines Supraleiters nach irgendeinem der Ansprüche 1 bis 8, umfassend mindestens einen Vorgang zur Einfügung mindestens einer supraleitenden Seele in eine Vorform des kryogenen Stabilisators, um einen Supraleiterrohling zu erzeugen, und **dadurch gekennzeichnet, dass** es die Bereitstellung einer Vorform des kryogenen Stabilisators nach einem der Ansprüche 9 bis 19 oder die Herstellung der Vorform gemäß dem Verfahren nach einem der Ansprüche 20 bis 25 umfasst.

27. Verfahren nach Anspruch 26, **dadurch gekennzeichnet, dass** der mindestens eine Einfügungsvorgang nach einem kontinuierlichen Coextrusionsverfahren durchgeführt wird.

28. Verfahren nach Anspruch 26, **dadurch gekennzeichnet, dass** die Vorform hohl ist und dass der mindestens eine Einfügungsvorgang eine Ausfütterung der Vorform umfasst.

29. Verfahren nach irgendeinem der Ansprüche 26 bis 28, **dadurch gekennzeichnet, dass** es mindestens einen Vorgang zur Querschnittsreduktion des durch den mindestens einen Einfügungsvorgang erzeugten Leiterrohlings umfasst.

30. Verfahren nach irgendeinem der Ansprüche 26 bis 28, **dadurch gekennzeichnet, dass** es zusätzlich umfasst:
- einen Vorgang zur Querschnittsreduktion des Leiterrohlings, um eine Zwischenform zu erhalten, deren Querschnitt gleich dem 1,10 bis 1,33-fachen Endquerschnitt des Supraleiters ist;
- gefolgt von einer thermischen Erholungsbehandlung der Zwischenform, die einen sog. "erholten" Rohling hervorbringt;
- gefolgt von einem Reduktionsvorgang zur Erzielung des Endquerschnitts des Rohlings auf kaltem Wege, um einen Supraleiter mit diesem Endquerschnitt zu erhalten.

31. Verfahren nach Anspruch 30, **dadurch gekennzeichnet, dass** die thermische Erholungsbehandlung während ca. 1 Stunde bei einer Temperatur zwischen ca. 150 und 350°C und gegebenenfalls unterhalb der Temperatur der nach dem Warmumformvorgang durchgeführten Warmauslagerungsbehandlung der Vorform durchgeführt wird.

32. Verwendung mindestens eines Supraleiters nach irgendeinem der Ansprüche 1 bis 8 in einer Magnetvorrichtung, wie z.B. einer supraleitenden Magnetspule.

## Claims

1. A superconducting conductor comprising at least one superconducting core and an aluminium-based cryogenic stabilizer, **characterized in that** said stabilizer is comprised, in whole or in part, of a high-purity Al-Fe-Ni aluminium alloy, having the composition:
200 ppm ≤ Fe + Ni ≤ 1,500 ppm ;
0.20 ≤ Fe / (Fe + Ni) ≤ 0.65;
optionally, B ≤ 100 ppm ;
the sum of the contents of inevitable impurities other than Fe, Ni and B < 0.01 % ; the remainder being aluminium.

2. The superconducting conductor according to Claim 1, **characterized in that** the total Fe + Ni content is less than or equal to 1,200 ppm.

3. The superconducting conductor according to Claim 1 or 2, **characterized in that** the inevitable impurities of said alloy comprise less than 10 ppm of Si and less than 5 ppm of Mn.

4. The superconducting conductor according to any one of Claims 1 to 3, **characterized in that** the sum of the contents of inevitable impurities other than Fe, Ni and B of said alloy is less than 0.005 %.

5. The superconducting conductor according to any one of Claims 1 to 3, **characterized in that** the sum of the contents of inevitable impurities other than Fe, Ni and B of said alloy is less than 0.001 %.

6. The superconducting conductor according to any one of Claims 1 to 5, **characterized in that** said alloy comprises between 20 and 100 ppm of boron.

7. The superconducting conductor according to any one of Claims 1 to 6, **characterized in that** the total quantity of Fe and Ni in solid solution in the aluminium of said alloy is less than 20 ppm.

8. The superconducting conductor according to any one of Claims 1 to 7, **characterized in that** it is in the form of a wire or cable.

9. A cryogenic stabilizer preform, **characterized in that** it is comprised, in whole or in part, of a high-purity Al-Fe-Ni aluminium alloy having the composition :
200 ppm ≤ Fe + Ni ≤ 1,500 ppm;
0.20 ≤ Fe / (Fe + Ni) ≤ 0.65;
optionally, B < 100 ppm ;
the sum of the contents of inevitable impurities other than Fe, Ni and B < 0.01 % ; the remainder being aluminium.

10. The preform according to Claim 9, **characterized in that** the total Fe + Ni content is less than or equal to 1,200 ppm.

11. The preform according to Claim 9 or 10, **characterized in that** the inevitable impurities of said alloy comprise less than 10 ppm of Si and less than 5 ppm of Mn.

12. The preform according to any one of Claims 9 to 11, **characterized in that** the sum of the contents of inevitable impurities other than Fe, Ni and B of said alloy is less than 0.005 %.

13. The preform according to any one of Claims 9 to 11, **characterized in that** the sum of the contents of inevitable impurities other than Fe, Ni and B of said alloy is less than 0.001 %.

14. The preform according to any one of Claims 9 to 13, **characterized in that** said alloy comprises between 20 and 100 ppm of boron.

15. The preform according to any one of Claims 9 to 14, **characterized in that** the total quantity of Fe and Ni in solid solution in the aluminium of said alloy is less than 20 ppm.

16. The preform according to any one of Claims 9 to 15, **characterized in that** it is in the form of a wire, a bar or a hollow bar.

17. The preform according to any one of Claims 9 to 16, **characterized in that** it is subjected to a hot mechanical working operation resulting in a reduction in cross-section by a factor at least equal to 10.

18. The preform according to Claim 17, **characterized in that** said hot mechanical working operation is effected at a temperature of between 200 and 400 °C.

19. The preform according to any one of Claims 17 or 18, **characterized in that** after said mechanical working operation, it is further subjected to a precipitation heat treatment comprising annealing of at least 8 hours at a temperature of between 300 °C and 400 °C.

20. A process for obtaining a cryogenic stabilizer preform according to one of Claims 9 to 16, **characterized in that** it comprises :
- the preparation by fusion and adjustment of said alloy ;
- the formation of a rough preform by solidification and shaping of said alloy, preferably in the form of an elongated product having a substantially constant transverse cross-section.

21. The process according to Claim 20, **characterized in that** said solidification and shaping are carried out by continuous or semi-continuous casting or by moulding.

22. The process according to Claim 20 or 21, **characterized in that** it comprises, in addition, a hot mechanical working of the rough preform with a reduction of the transverse cross-section of at least 90 %.

23. The process according to Claim 22, **characterized in that** the mechanical working operation is carried out by extrusion or by rolling.

24. The process according to Claim 22 or 23, **characterized in that** the hot mechanical working operation is carried out at a temperature of between 200 and 400 °C.

25. The process according to any one of Claims 22 to 24, **characterized in that** after the mechanical working operation it comprises, in addition, a precipitation heat treatment of the preform at a temperature of between 300 and 400 °C over a period of at least 8 hours.

26. A process for manufacturing a superconducting conductor according to any one of Claims 1 to 8, comprising at least one operation of inserting at least one superconducting core into a cryogenic stabilizer preform to produce a superconducting conductor blank and **characterized in that** it comprises the provision of a cryogenic stabilizer preform according to one of Claims 9 to 19 or the manufacture of said preform by the process of one of Claims 20 to 25.

27. The process according to Claim 26, **characterized in that** said at least one insertion operation is effected by a process of continuous co-extrusion.

28. The process according to Claim 26, **characterized in that** said preform is hollow and **in that** said at least one insertion operation comprises filling of the preform.

29. The process according to any one of Claims 26 to 28, **characterized in that** it comprises at least one operation for reducing the cross-section of the conductor blank produced by said at least one insertion operation.

30. The process according to any one of Claims 26 to 29, **characterized in that** it in addition comprises :
- an operation for reducing the cross-section of the conductor blank so as to obtain an intermediate blank whose cross-section is between 1.10 and 1.33 times the final cross-section of said superconducting conductor;
- followed by a recovery heat treatment of said intermediate blank, which produces a so-called "restored" blank;
- followed by a final cold reduction of the cross-section of said restored blank so as to obtain a superconducting conductor having said final cross-section.

31. The process according to Claim 30, **characterized in that** said recovery heat treatment is carried out over a period of approximately 1 hour at a temperature of between approximately 150 and 350 °C and, if applicable, less than that of the precipitation treatment carried out after the mechanical working of the preform.

32. Use of at least one superconducting conductor according to any one of Claims 1 to 8 in a magnetic device such as a superconducting magnetic coil.
